# EUROPEAN PATENT APPLICATION

(11) **EP 4 729 957 A1**
(43) Date of publication of application: **22.04.2026**
(21) Application number: 24306708.9
(22) Date of filing: 16.10.2024
(51) Int. Cl.: G01R 31/28, G06F 11/30, G06F 11/00, G06F 11/22, G06F 11/27, G06F 1/28

(54) **SMART SELF-DIAGNOSTIC SCHEME FOR PREDICTABLE FAILURE AND EXTENDED RELIABILITY IN EMBEDDED SYSTEMS**

(71) Applicant: NXP USA, Inc., Austin, TX 78735 (US)
(72) Inventor: Meunier, Jean-Philippe, 31023 Toulouse (FR); Hureau, Loic, 31023 Toulouse (FR); McKenna, Daniel, 31023 Toulouse (FR); El Sherif, Alaa Eldin Y, 31023 Toulouse (FR); Jin, Xiankun, 31023 Toulouse (FR)
(74) Representative: Miles, John Richard

(57) **Abstract**

Methods and systems are described for monitoring and diagnosing the health of a processing unit within an embedded system using a power management integrated circuit (PMIC). The PMIC measures the current power consumption and temperature of the processing unit and compares these measurements against expected ranges derived from mission profiles, operational modes, and/or historical data. An alert is generated to prompt corrective action if the measurements are determined to be outside an expected range.

## Description

### BACKGROUND

Advancements in vehicular and other technologies have led to widespread integration of embedded systems having one or more processing units. Such processing units include microcontroller units (MCUs) and other electronic control units in various embedded systems, such as those in modern vehicles. For example, in modern vehicles MCUs manage various functions ranging from engine control to advanced driverassistance systems (ADAS). The reliability and longevity of these electronic components facilitate safety and performance for automotive and other embedded systems.

One challenge associated with the embedded systems is detection and prediction of potential failures in processing units due to aging and current drift effects. Over time, the performance of these devices (like other semiconductor devices) can degrade due to various factors, such as temperature fluctuations, electrical stress, and material fatigue. This degradation can lead to increased leakage currents, changes in transistor threshold voltages, and ultimately, functional failures.

Conventional approaches for monitoring the health of processing units in embedded systems often rely on periodic maintenance and diagnostics conducted during service intervals. However, these approaches often fail to provide sufficient warning to prevent unexpected failures, which can compromise safety and reliability for the embedded system. Moreover, the lack of real-time monitoring capabilities makes it difficult to track operating conditions and usage patterns that contribute to the aging of these electronic components.

### BRIEF DESCRIPTION OF THE DRAWINGS

The present disclosure may be better understood, and its numerous features and advantages made apparent to those skilled in the art by referencing the accompanying drawings. The use of the same reference symbols in different drawings indicates similar or identical items.
FIG. 1 illustrates an age graph showing aging and drifting effects on an embedded system.
FIG. 2 illustrates a block diagram of an embedded system for monitoring and reporting aging effects using a power management integrated circuit, in accordance with some embodiments.
FIG. 3 illustrates a block diagram of a system for monitoring power and thermal conditions within an embedded processor, in accordance with some embodiments.
FIG. 4 is a flow diagram for an operational routine, in accordance with some embodiments.
FIG. 5 is a flow diagram for an operational routine, in accordance with some embodiments.

### DETAILED DESCRIPTION

An embedded system is a specialized computing system that is designed to perform dedicated functions or tasks within a larger system. Unlike general-purpose computers, embedded systems are typically integrated into the hardware they control, often with real-time computing constraints. These systems typically include a combination of hardware and software, with a single embedded processing unit including one or more processors, memory, input/output (I/O) interfaces, and executable instruction code typically stored in firmware and designed to enable the processing unit to perform specific predefined tasks. Embedded systems are commonly found in a wide range of applications, including automotive and other vehicular systems, industrial machines, consumer electronics, and medical devices, in which they may perform critical and noncritical control, monitoring, and processing functions.

One challenge for embedded system maintenance is the need for accurate and continuous measurement of parameters such as core current and temperatures within a processing unit. These parameters are influenced by various factors, including operating modes, environmental conditions, and the intrinsic properties of semiconductor materials used in the processing unit, such as can lead to current drift. As used herein, current drift (or simply drift) is the gradual change in the amount of electrical current drawn by a circuit or component over time, often due to factors such as aging, temperature variations, or degradation of materials. Current drift can indicate underlying issues such as increased leakage currents, changes in component characteristics, or failures in the power regulation system. Monitoring current drift is important for assessing the health and reliability of electronic systems, as significant deviations from expected current levels can signal potential problems that may lead to functional failures. Without precise and timely data, it becomes challenging to predict potential failures and implement preventative measures.

As used herein, a mission profile is a detailed specification of the expected operating conditions and usage patterns of a system or component over its lifespan. In various scenarios, a mission profile includes parameters for the system or component such as temperature ranges, voltage levels, load conditions, operational modes, and the duration of exposure to these conditions. A mission profile serves as a benchmark against which the actual performance and aging of the system or component can be measured. For example, in the context of automotive or other vehicular embedded systems, a mission profile helps define the environmental and operational stresses that the system is expected to endure, allowing for the prediction of potential failures and the implementation of preventive maintenance strategies. Generally, mission profile parameters specify the operating conditions and usage patterns over an indicated lifespan. However, collecting and analyzing system monitoring data with respect to such mission profile parameters in real-time is a complex task that requires robust data acquisition and processing capabilities.

Embodiments of techniques described herein enable diagnostic and predictive maintenance systems that can monitor the health of embedded processing units in real-time, accurately measure key parameters, and analyze mission profile information to predict potential failures. These embodiments include approaches for real-time monitoring of critical parameters such as voltage, temperature, and current, as well as the analysis of mission profiles to assess the long-term reliability of the incorporating system. By utilizing integrated sensors, data processing units, and communication interfaces, the described techniques enable proactive maintenance strategies, allowing for early detection of potential failures and the implementation of corrective actions before critical issues arise. The described embodiments can be applied across various automotive and industrial applications to enhance the safety, efficiency, and durability of electronic systems.

For ease of illustration, examples described herein may refer to a microcontroller unit (MCU) type of processing unit. It will be appreciated that in various embodiments and scenarios, the techniques described herein may be used by and in conjunction with other types of processing units, such as real-time processing units (RTPUs), digital signal processors (DSPs), application-specific integrated circuits (ASICs), field-programmable gate arrays (FPGAs), central processing units (CPUs), etc.

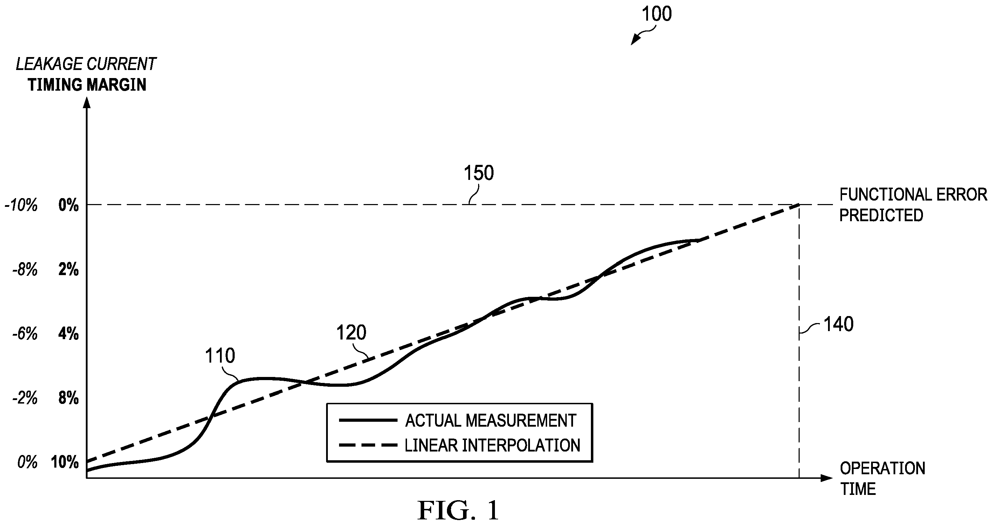

FIG. 1 depicts an age graph 100, which illustrates aging and drifting effects on an MCU by depicting the relationship between leakage current and timing margin over operation time for that MCU. The graph 100 includes an x-axis representing operation time and a y-axis representing both the leakage current and timing margin, and provides a comparison between actual measurements and linear interpolation to predict functional errors.

As used herein, timing margin refers to a buffer time available within the operating cycle of an MCU before a timing failure occurs. It represents the difference between the actual operation time required for a task and the maximum allowable time for that task to be completed without error. A larger timing margin indicates a more reliable system with greater tolerance to variations in processing time, while a smaller timing margin signifies a higher risk of timing-related errors. In the context of the diagnostic scheme described herein, monitoring the timing margin enables the detection of aging effects that can cause delays in the MCU's operation, potentially leading to functional failures.

In the example of FIG. 1, the timing margin is shown along the y-axis on the left side of the age graph 100 with leakage current, and decreases as the leakage current increases. The dual representation of timing margin and leakage current on the y-axis highlights their inverse relationship and the impact of increased leakage current on the timing performance of the MCU.

The actual measurement of leakage current is indicated by the leakage current measurement plot 110, which represents actual observed leakage current in the MCU over a period of operation time. As operation time increases, the actual leakage current is shown to rise, indicating the aging effect on the MCU.

A linear interpolation plot 120 represents the expected trend of leakage current based on initial measurements, and is projected over time in order to estimate an expected increase in leakage current.

Based on the linear interpolation plot 120, a functional error is predicted at operation time 140. This point marks the threshold 150 at which the increase in leakage current (or the decrease in timing margin due to aging effects) is expected to cause a functional failure in the MCU.

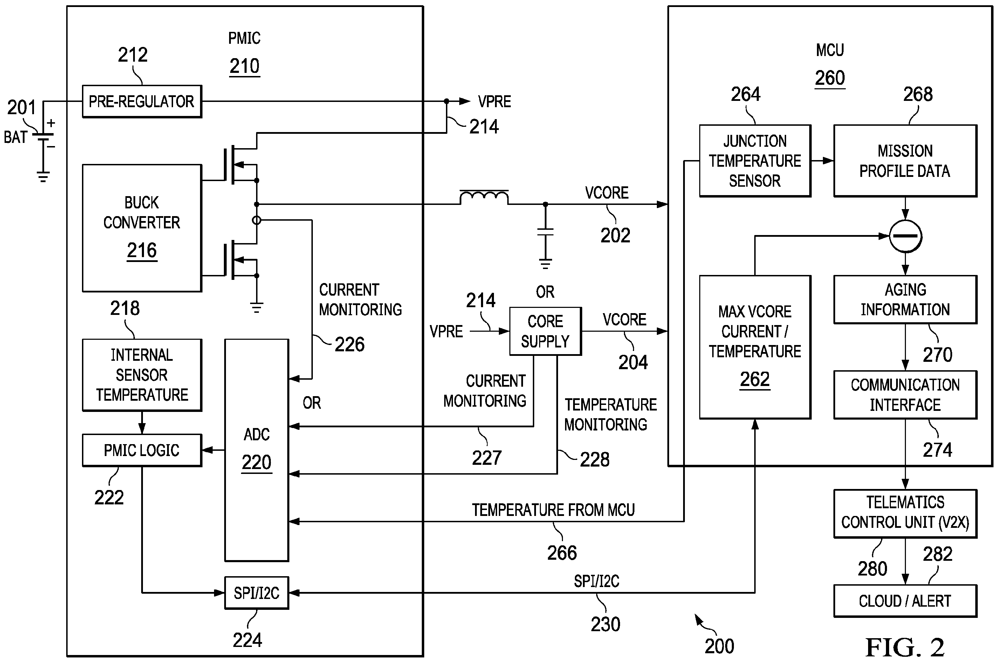

FIG. 2 illustrates a block diagram of an embedded system 200 for monitoring and reporting aging effects in an MCU using a power management integrated circuit (PMIC), in accordance with some embodiments. The system 200 comprises a PMIC 210 and an MCU 260.

In the depicted embodiment, the PMIC 210 is connected to a power source (*e.g*., battery) 201 and includes a pre-regulator 212, which steps down the voltage from the battery level to a regulated pre-regulation voltage (VPRE) 214. This VPRE 214 is then supplied to a buck converter 216. As used herein, a buck converter is a type of DC-DC power converter configured to efficiently reduce the voltage level in power supply systems, allowing the delivery of a lower, stable voltage to sensitive components such as the MCU 260. In the depicted embodiment, the buck converter 216 further steps down the voltage to the core supply voltage (Vcore) 202 for the MCU 260.

The PMIC 210 also incorporates a temperature sensor 218, which provides junction temperature data to the PMIC processing logic 222.

The PMIC processing logic 222 is responsible for managing various control and monitoring operations within the PMIC 210, including the regulation of power outputs, the initiation of ADC conversions, and the processing of sensor data. This logic ensures that the PMIC 210 functions efficiently under different operating conditions, including varying temperatures and loads. It may also include algorithms for filtering noise from sensor data, controlling switching frequencies, and handling communication protocols with the MCU 260. In the depicted embodiment, the PMIC 210 is configured to measure a current power consumption and current temperature of the MCU 260 and/or of the PMIC 210 (*e.g.,* junction temperature), and to provide information indicative of those measurements to the MCU 260 for further processing in view of current operational mode, mission profile information, and historical data for the MCU 260.

The Analog-to-Digital Converter (ADC) 220 converts analog signals, such as analog current and temperature measurements, into digital signals for processing by the PMIC 210 (via PMIC processing logic 222) and MCU 260. In some embodiments, the ADC 220 receives current monitoring information from current measurement 226, which is taken from the output Vcore 202 of the buck converter 216. In other embodiments, the ADC 220 receives current monitoring data 227 and temperature monitoring data 228 from Vcore 204, which is fed from VPRE 214. In either alternative configuration, the junction temperature sensor 264 provides its temperature reading 266 to the ADC 220.

The converted digital environment signals 230 are then communicated to the MCU 260 via a Serial Peripheral Interface (SPI) and/or Inter-Integrated Circuit (I2C) bus 224. In various embodiments, additional types of communications buses may be utilized. The SPI/I2C bus 224 is a communication interface that allows the PMIC 210 to transmit data to the MCU 260. SPI is a synchronous serial communication protocol used for shortdistance communication, mainly in embedded systems. I2C is another synchronous communication protocol that allows multiple slave devices to be controlled by a single master. Both SPI and I2C enable the exchange of information between the PMIC 210 and the MCU 260, ensuring that the data required for monitoring and analysis is accurately transferred.

The MCU 260 receives its operating core voltage either as Vcore 202 or as Vcore 204, depending on the alternative system configuration employed. The MCU 260 also receives temperature data from both the PMIC 210 (via environment signals 230) and an internal junction temperature sensor 264. In various embodiments, the temperature sensor 264 may be located elsewhere or may be used in conjunction with one or more additional sensors, such as one or more sensors located externally to the MCU to collect ambient temperature information. Based on that information, the MCU 260 is configured to determine whether the measured current power consumption and the current temperature are within an expected range for the MCU 260, such as based on mission profile data 268 associated with the MCU 260 and/or a current operational mode of the MCU, and/or on historical data associated with the MCU and/or its current operational mode.

In some embodiments, the MCU 260 is configured to determine an expected power consumption range and/or an expected temperature range for the MCU 260 based on a predicted failure of the MCU. This prediction may be derived from historical performance data, mission profile information, and real-time measurements collected during various operational modes. In certain embodiments, the MCU 260 utilizes this information to dynamically adjust the expected power consumption and/or temperature ranges, taking into account known aging effects or degradation patterns that are likely to lead to failure. For example, as the MCU 260 approaches a predicted failure point, the expected power consumption range and temperature range may tighten, allowing the system to detect deviations that indicate further progression toward failure. This dynamic adjustment enables monitoring the MCU 260's health with increasing sensitivity as the probability of failure rises, enabling proactive maintenance or shutdown before critical system failures occur.

Information regarding a maximum Vcore current and temperature, as reported by the PMIC 210, are stored in the MCU 260 as maximum Vcore current/temperature information 262. In operation, the MCU 260 compares the received data from the junction temperature sensor 264 against mission profile data 268 stored in its memory. The mission profile data 268 includes expected maximum current versus temperature data, which is derived from the operational conditions the MCU is expected to encounter over its lifetime. The mission profile data 268 enables the MCU to determine whether it is operating within its expected parameters or if it is experiencing conditions that could accelerate aging or lead to potential failures. This information provides a reference against which the actual measurements are compared.

The comparison results in the determination of aging information 270, which represents the difference between the reference current and temperature values from the mission profile and the real measurements from the PMIC 210. This aging information 270 provides insights into the current status of the MCU, identifying any deviations that may indicate aging or impending failure.

The MCU 260 includes a communication interface 274 that sends the aging information 270 to a telematics control unit 280. This unit, part of the vehicle's telematics system, forwards one or more signals indicative of the aging information 270 to one or more destinations. For example, in certain embodiments and scenarios, the telematics control unit 280 may alert one or more entities associated with the MCU 260 and/or PMIC 210, such as the manufacturer of the MCU or incorporating vehicle, even though that entity is located remotely from the MCU. In certain embodiments, the alerted entities include the driver (such as by activating an in-vehicle alert system to indicate that the driver should schedule maintenance operations or other modification for the incorporating vehicle). In this manner, the MCU 260 (via communication interface 274) provides the aging information 270 for remote diagnostics and/or maintenance planning.

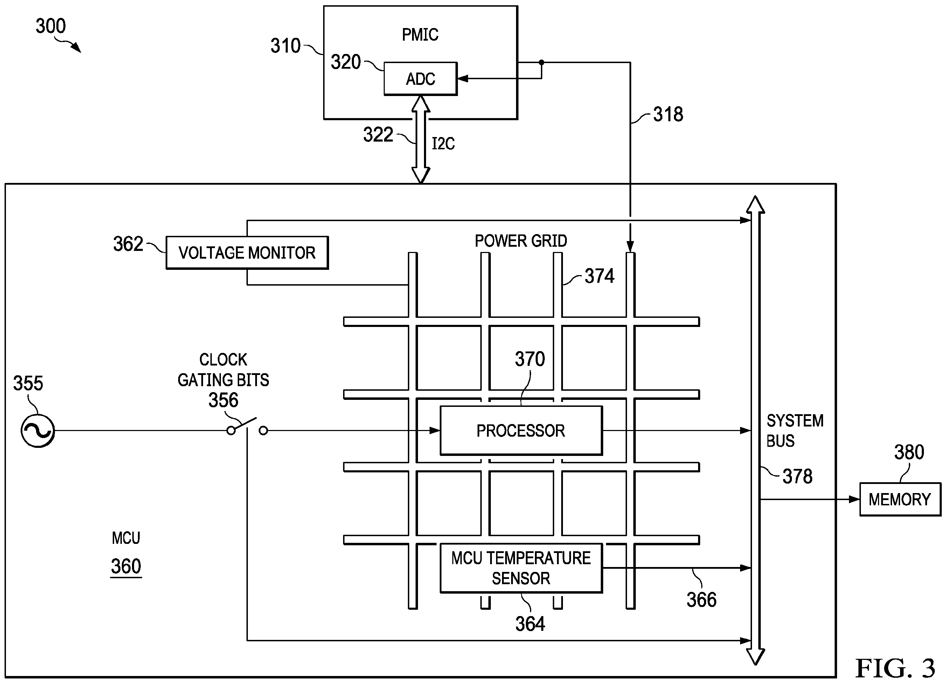

FIG. 3 illustrates a block diagram of a system 300 for monitoring power and thermal conditions within an embedded processor 370 (such as may be, in certain embodiments and scenarios, part of a larger embedded system, not shown). The system 300 integrates various monitoring components and communication pathways to ensure reliable operation of the processor 370 over time. The diagram depicts the interaction between a PMIC 310, MCU 360, and processor 370 to monitor voltage and temperature, and how this information is stored and communicated for further action and/or analysis.

In the depicted embodiment, the PMIC 310 includes an Analog-to-Digital Converter (ADC) 320, which converts analog signals related to voltage and temperature into digital data. The ADC 320 receives input from one or more monitoring points within the system, such as one or more current monitors, temperature sensors, etc. The PMIC 310 supplies power 318 to the processor 370 via the MCU's power grid 374. Additionally, the PMIC 310 communicates with the MCU 360 via an I2C bus 322, facilitating data exchange and control signaling between the PMIC 310 and the processor 370.

The processor 370 is housed within the MCU 360, which also includes an MCU temperature sensor 364 that monitors the thermal conditions surrounding the processor 370. This sensor provides real-time temperature data to the processor 370, helping to assess the thermal performance of the system and detect potential overheating issues.

The power grid 374 within the MCU 360 distributes power supplied by the PMIC 310 to the processor 370 and other components. In various embodiments, the processor 370 may be any type of hardware processor such as a microcontroller, real-time processing unit, or similar device.

In the depicted embodiment, the MCU 360 utilizes a system bus 378 as a communication pathway that enables data exchange between the processor 370 and other components, as well as (in certain scenarios) with external devices. In particular, the system bus 378 facilitates communication between the processor 370 and memory 380. In certain embodiments, the memory 380 is a non-volatile memory that enables the MCU 360 to store data (such as voltage and temperature readings, as well as operational parameters) even when the system 300 is powered down. A clock signal 355 and associated clock gating bits 356 control the timing and synchronization of the processor 370 and its subsystems (such as via system bus 378).

In various embodiments, the operation of an embedded system, including the diagnostic operational routines described herein, is influenced by one or more operational modes of that system. For example, an MCU 360 may operate in different modes depending on the specific tasks it is executing, the environmental conditions, and the overall system requirements. These operational modes can include, but are not limited to, full operating mode, standby mode, boot mode, and Built-In Self-Test (BIST) mode.

In full operating mode, the MCU 360 is executing its primary functions and managing the vehicle's systems in real-time. This mode typically involves the highest levels of power consumption and processing activity, as the MCU 360 is fully engaged in controlling and monitoring the operations of its incorporating embedded system. In this mode, the MCU 360 may perform continuous diagnostics to ensure that the MCU 360 is operating within expected parameters, given its mission profile.

In standby mode, the MCU 360 reduces its power consumption and processing activity, maintaining only essential functions while awaiting further instructions or events. Standby mode is typically employed when the vehicle is idle or during periods of low activity. During this mode, diagnostic tests may be scheduled less frequently or be triggered by specific events to conserve energy while still monitoring critical parameters.

Boot mode is the initial mode of operation when the MCU 360 is starting up. In this mode, the MCU 360 performs internal checks and initializes its subsystems before transitioning to full operating mode. Diagnostic routines during boot mode focus on ensuring that the MCU 360 is ready for operation and that all systems are functioning correctly before the vehicle begins operation.

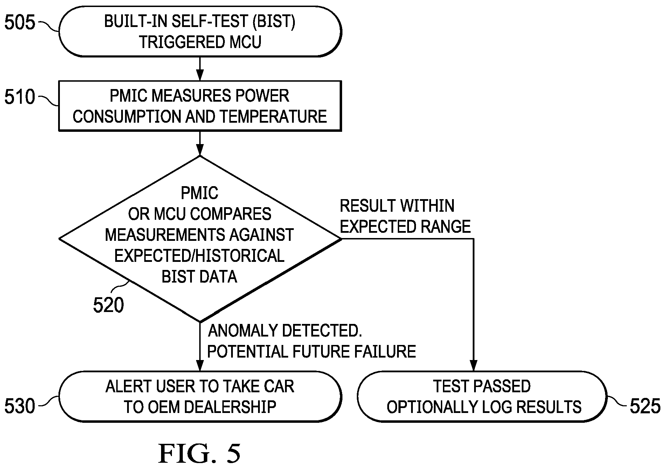

BIST mode is a diagnostic mode in which the MCU 360 performs a selfassessment to verify the integrity of its components. This mode involves running one or more predefined test sequences that stress the MCU's circuits to detect any potential faults. The results from BIST mode are critical for identifying issues that may not be apparent during normal operation. As described below with respect to FIG. 5, the results from BIST mode are compared against historical BIST data to assess the MCU's health.

Generally, a particular operational mode determines the context in which the PMIC 310 measures power consumption and temperature, as well as how the diagnostic results are interpreted. For example, the expected power consumption and thermal profile during full operating mode will differ substantially from those in standby or boot mode. Consequently, in various embodiments the described diagnostic routines are adapted to account for these differences, ensuring that the system accurately detects potential issues under varying conditions. Understanding and accounting for the MCU's operational modes allows the system to provide more reliable and context-sensitive diagnostics, ultimately enhancing the safety and reliability of the embedded system.

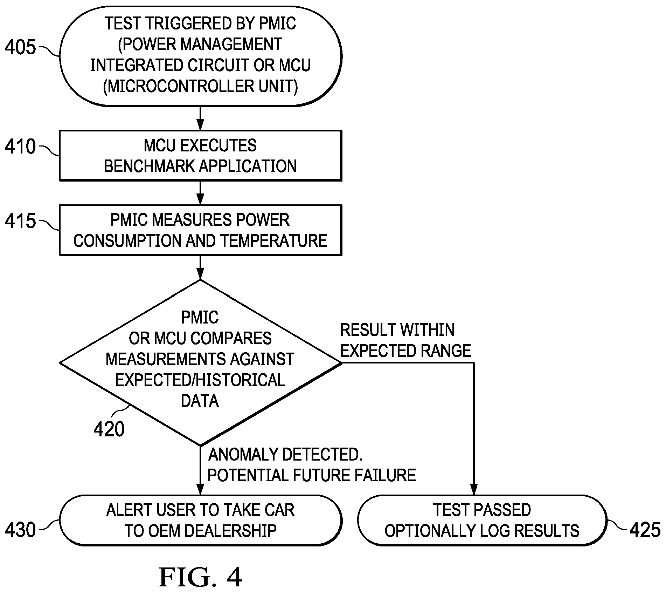

FIG. 4 is a flow diagram for an operational routine 400, in accordance with some embodiments. The routine 400 may be performed, for example, by an embedded system (such as embedded system 200 of FIG. 2 or system 300 of FIG. 3) having a PMIC (*e.g.,* PMICs 210, 310 of FIGs. 2 and 3, respectively) coupled to an embedded processing unit (*e.g.,* MCU 260 of FIG. 2 or MCU 360 of FIG. 3).

The operational routine 400 begins at step 405, in which a diagnostic test is initiated. In various embodiments and scenarios, the diagnostic test may be initiated by either the PMIC or the MCU, depending on the system configuration and the specific monitoring strategy in use. For example, initiation of the test may be scheduled, eventdriven, or based on predefined conditions related to the operational environment (e.g., based on data from an internal PMIC temperature sensor) or mission profile data of the system. The routine proceeds to step 410.

At step 410 the MCU proceeds to execute a benchmark application. In certain embodiments, the benchmark application is designed to simulate typical and/or worstcase operating conditions for the MCU, providing a controlled environment in which to measure key performance indicators such as power consumption and temperature. The routine proceeds to step 415.

At step 415, the PMIC measures the power consumption and temperature of the MCU during the execution of the benchmark application. The PMIC gathers this data using internal monitoring capabilities, such as those described above with respect to PMIC 210 of FIG. 2. After the measurements have been taken, the routine proceeds to 420.

At step 420, the PMIC or MCU compares the measured values against expected data values. The expected data values may be derived, as a non-limiting example, based on mission profile information and/or historical data (e.g., performance log data) associated with the MCU and/or with a current operational mode of the MCU. In certain embodiments, deriving the expected data values may include calculating one or more differences between mission profile information and the actual measurements. In some embodiments, the MCU stores information indicative of the measured current power consumption and the current temperature measurement in non-volatile memory for future use (such as for use as historical data for the MCU when performing future diagnostic tests).

If it is determined at step 420 that the results are within an expected range, the routine 400 proceeds to step 425, at which the test is considered passed. At this point, the results may be optionally logged for future reference, contributing to the historical data that will be used in subsequent tests.

However, if an anomaly is detected during the comparison at step 420-indicating a potential future failure or deviation from normal operation-the routine proceeds to step 430, where an alert is generated to inform the user of the potential issue. This alert may instruct the user to take the vehicle to an OEM dealership for further inspection or maintenance, helping to prevent unexpected failures and ensuring continued reliability of the system. As noted elsewhere herein, in certain embodiments the alert may be provided to one or more entities associated with the MCU, such as via one or more communication interfaces.

The operational routine 400 provides a sequence of operations for using the PMIC and MCU to monitor the health of the system, allowing for proactive maintenance and reducing the likelihood of unexpected failures. By comparing real-time data against historical or expected values, the system can detect early signs of aging or drift, enabling timely intervention.

FIG. 5 is a flow diagram for an operational routine 500, in accordance with some embodiments. The routine 500 may be performed, for example, by an embedded system (such as embedded system 200 of FIG. 2 or system 300 of FIG. 3) having a PMIC (e.g., PMICs 210, 310 of FIGs. 2 and 3, respectively) coupled to an embedded processing unit (e.g., MCU 260 of FIG. 2 or MCU 360 of FIG. 3).

The operational routine 500 begins at step 505, in which a Built-In Self-Test (BIST) is triggered. In various embodiments, the BIST may be triggered by the MCU as part of its diagnostic routines, such as when first powered or in another defined scenario. In certain embodiments and scenarios, the BIST may be performed, for example, at start up or shut down for the embedded system. The BIST is designed to assess the integrity and functionality of the MCU by running a series of internal tests that check the proper operation of the MCU's components. The routine then proceeds to step 510.

At step 510, the PMIC measures the power consumption and temperature of the MCU during the execution of the BIST. These measurements enable assessment of whether the MCU is operating within expected parameters during the BIST. The PMIC gathers this data using its internal monitoring capabilities, such as those described above with respect to PMIC 210 of FIG. 2. After the measurements have been taken, the routine proceeds to step 520.

At step 520, the PMIC or MCU compares the measured values against expected or historical BIST data. The expected data may be derived from initial BIST results or from historical performance logs stored within the system. This comparison helps identify any deviations from normal operation that could indicate potential issues within the MCU. The routine evaluates whether the measured results are within the expected range.

If it is determined at step 520 that the results are within the expected range, the routine 500 proceeds to step 525, at which the BIST is considered passed. The results of the test may be optionally logged for future reference, contributing to the historical data that will be used in subsequent diagnostics.

However, if an anomaly is detected during the comparison at step 520-indicating a potential future failure or deviation from normal operation-the routine proceeds to step 530, where an alert is generated to inform the user of the potential issue. This alert may instruct the user to take the vehicle to an OEM dealership for further inspection or maintenance. As with other alerts described in this specification, the alert may also be communicated to relevant entities associated with the MCU via one or more communication interfaces.

Methods and systems are described for monitoring and diagnosing the health of a processing unit within an embedded system using a power management integrated circuit (PMIC). The PMIC measures the current power consumption and temperature of the processing unit and compares these measurements against expected ranges derived from mission profiles, operational modes, and/or historical data. An alert is generated to prompt corrective action if the measurements are determined to be outside an expected range.

Aspects of the disclosure are defined in the accompanying claims. In a first aspect there is provided a system, comprising: a processing unit comprising one or more processors and at least one temperature sensor; and a power management integrated circuit (PMIC) coupled to the processing unit, the PMIC configured to: measure a current power consumption of the processing unit; and receive a current temperature measurement from the at least one temperature sensor of the processing unit; wherein one of the processing unit or the PMIC is configured to: perform a first comparison of the measured current power consumption to an expected power consumption range for the processing unit; and perform a second comparison of the current temperature measurement to an expected temperature range for the processing unit; and wherein the processing unit is configured to generate an alert in response to: a determination based on the first comparison that the measured current power consumption is outside of the expected power consumption range; or a determination based on the second comparison that the current temperature measurement is outside of the expected temperature range for the processing unit.

In some embodiments at least one of the first comparison or the second comparison is performed as at least part of a diagnostic test initiated in response to one or more defined conditions associated with one or more of an operational mode of the processing unit or a mission profile of the processing unit.

In some embodiments, the diagnostic test comprises a built-in self-test (BIST) of the processing unit.

In some embodiments, the PMIC comprises an internal PMIC temperature sensor, and wherein the diagnostic test is initiated by the PMIC based at least in part on data from the internal PMIC temperature sensor.

In some embodiments, the processing unit is further configured to determine at least one of the expected power consumption range or the expected temperature range based at least in part on one or more of a group that includes an operational mode of the processing unit, mission profile data associated with the processing unit, or historical data associated with the processing unit.

In some embodiments, at least one of the expected power consumption range or the expected temperature range is based at least in part on a predicted failure of the processing unit.

In some embodiments, the processing unit is configured to store information indicative of the measured current power consumption and the current temperature measurement in a non-volatile memory for future use as historical data associated with the processing unit.

In some embodiments, to generate the alert comprises alerting a user of the processing unit to schedule maintenance operations for a system incorporating the processing unit.

In some embodiments, to generate the alert comprises initiating a transmission of information indicative of the alert to an entity associated with the processing unit, the entity being located remotely from the processing unit.

In a second aspect, there is provided a method comprising: measuring, by a power management integrated circuit (PMIC) coupled to a processing unit, a current power consumption of the processing unit; receiving, by the PMIC, a current temperature of the processing unit; comparing, by one of the processing unit or the PMIC, the measured current power consumption to an expected power consumption range for the processing unit; comparing, by one of the processing unit or the PMIC, the current temperature of the processing unit to an expected temperature range for the processing unit; and generating, by the processing unit, an alert in response to the measured current power consumption being outside the expected power consumption range or the current temperature measurement being outside of the expected temperature range.

In some embodiments, the measuring is performed in response to one or more defined conditions associated with one or more of an operational mode of the processing unit or a mission profile of the processing unit.

In some embodiments, the measuring comprises initiating a built-in self-test (BIST) of the processing unit.

In some embodiments, receiving the current temperature of the processing unit comprises receiving information indicative of a first temperature from a first temperature sensor of the PMIC and receiving information indicative of a second temperature from a second temperature sensor of the processing unit.

In some embodiments, the method further comprises determining at least one of the expected power consumption range or the expected temperature range based at least in part on one or more of a group that includes an operational mode of the processing unit, mission profile data associated with the processing unit, or historical data associated with the processing unit.

In some embodiments, determining at least one expected range of the expected power consumption range or the expected temperature range comprises determining the at least one expected range based at least in part on a predicted failure of the processing unit.

In some embodiments, the method further comprising storing information indicative of the measured current power consumption and current temperature in non-volatile memory for future use as historical data associated with the processing unit.

In some embodiments, generating the alert comprises alerting a user of the processing unit to schedule maintenance operations for a system incorporating the processing unit.

In some embodiments, generating the alert comprises initiating a transmission of the alert to an entity associated with the processing unit, the entity being located remotely from the processing unit.

In a third aspect, there is provided a non-transitory computer readable medium storing a set of executable instructions that, when executed by one or more processors, manipulates the one or more processors to: receive, from a power management integrated circuit (PMIC) coupled to the one or more processors, information indicating a current power consumption of the one or more processors; receive information indicating a current temperature of the one or more processors; compare the current power consumption to an expected power consumption range for the processing unit; compare the current temperature to an expected temperature range for the processing unit; and generate an alert responsive to the current power consumption being outside the expected power consumption range or the current temperature being outside the expected temperature range for the one or more processors.

In some embodiments, the set of executable instructions further manipulates the one or more processors to determine at least one of the expected power consumption range or the expected temperature range based at least in part on a predicted failure of at least one processor of the one or more processors, the predicted failure being based on one or more of a group that includes an operational mode of the at least one processor, mission profile data associated with the at least one processor, or historical data associated with the at least one processor.

In some embodiments, certain aspects of the techniques described above may implemented by one or more processors of a processing system executing software. The software comprises one or more sets of executable instructions stored or otherwise tangibly embodied on a non-transitory computer readable storage medium. The software can include the instructions and certain data that, when executed by the one or more processors, manipulate the one or more processors to perform one or more aspects of the techniques described above. The non-transitory computer readable storage medium can include, for example, a magnetic or optical disk storage device, solid state storage devices such as Flash memory, a cache, random access memory (RAM) or other non-volatile memory device or devices, and the like. The executable instructions stored on the non-transitory computer readable storage medium may be in source code, assembly language code, object code, or other instruction format that is interpreted or otherwise executable by one or more processors.

A computer readable storage medium may include any storage medium, or combination of storage media, accessible by a computer system during use to provide instructions and/or data to the computer system. Such storage media can include, but is not limited to, optical media (e.g., compact disc (CD), digital versatile disc (DVD), Blu-Ray disc), magnetic media (e.g., floppy disk, magnetic tape, or magnetic hard drive), volatile memory (e.g., random access memory (RAM) or cache), non-volatile memory (e.g., read-only memory (ROM) or Flash memory), or microelectromechanical systems (MEMS)-based storage media. The computer readable storage medium may be embedded in the computing system (e.g., system RAM or ROM), fixedly attached to the computing system (e.g., a magnetic hard drive), removably attached to the computing system (e.g., an optical disc or Universal Serial Bus (USB)-based Flash memory), or coupled to the computer system via a wired or wireless network (e.g., network accessible storage (NAS)).

Note that not all of the activities or elements described above in the general description are required, that a portion of a specific activity or device may not be required, and that one or more further activities may be performed, or elements included, in addition to those described. Still further, the order in which activities are listed are not necessarily the order in which they are performed. Also, the concepts have been described with reference to specific embodiments. However, one of ordinary skill in the art appreciates that various modifications and changes can be made without departing from the scope of the present disclosure as set forth in the claims below. Accordingly, the specification and figures are to be regarded in an illustrative rather than a restrictive sense, and all such modifications are intended to be included within the scope of the present disclosure.

Benefits, other advantages, and solutions to problems have been described above with regard to specific embodiments. However, the benefits, advantages, solutions to problems, and any feature(s) that may cause any benefit, advantage, or solution to occur or become more pronounced are not to be construed as a critical, required, or essential feature of any or all the claims. Moreover, the particular embodiments disclosed above are illustrative only, as the disclosed subject matter may be modified and practiced in different but equivalent manners apparent to those skilled in the art having the benefit of the teachings herein. No limitations are intended to the details of construction or design herein shown, other than as described in the claims below. It is therefore evident that the particular embodiments disclosed above may be altered or modified and all such variations are considered within the scope of the disclosed subject matter. Accordingly, the protection sought herein is as set forth in the claims below.

## Claims

1. A system, comprising:
a processing unit comprising one or more processors and at least one temperature sensor; and
a power management integrated circuit (PMIC) coupled to the processing unit, the PMIC configured to:
measure a current power consumption of the processing unit; and
receive a current temperature measurement from the at least one temperature sensor of the processing unit;
wherein one of the processing unit or the PMIC is configured to:
perform a first comparison of the measured current power consumption to
an expected power consumption range for the processing unit; and perform a second comparison of the current temperature measurement to
an expected temperature range for the processing unit; and
wherein the processing unit is configured to generate an alert in response to:
a determination based on the first comparison that the measured current power consumption is outside of the expected power consumption range; or
a determination based on the second comparison that the current temperature measurement is outside of the expected temperature range for the processing unit.

2. The system of claim 1, wherein at least one of the first comparison or the second comparison is performed as at least part of a diagnostic test initiated in response to one or more defined conditions associated with one or more of an operational mode of the processing unit or a mission profile of the processing unit.

3. The system of claim 2, wherein the diagnostic test comprises a built-in self-test (BIST) of the processing unit.

4. The system of any of claims 2 or 3, wherein the PMIC comprises an internal PMIC temperature sensor, and wherein the diagnostic test is initiated by the PMIC based at least in part on data from the internal PMIC temperature sensor.

5. The system of any preceding claim, wherein the processing unit is further configured to determine at least one of the expected power consumption range or the expected temperature range based at least in part on one or more of a group that includes an operational mode of the processing unit, mission profile data associated with the processing unit, or historical data associated with the processing unit.

6. The system of any preceding claim, wherein at least one of the expected power consumption range or the expected temperature range is based at least in part on a predicted failure of the processing unit.

7. The system of any preceding claim, wherein the processing unit is configured to store information indicative of the measured current power consumption and the current temperature measurement in a non-volatile memory for future use as historical data associated with the processing unit.

8. The system of any preceding claim, wherein to generate the alert comprises alerting a user of the processing unit to schedule maintenance operations for a system incorporating the processing unit.

9. The system of any preceding claim, wherein to generate the alert comprises initiating a transmission of information indicative of the alert to an entity associated with the processing unit, the entity being located remotely from the processing unit.

10. A method comprising:
measuring, by a power management integrated circuit (PMIC) coupled to a processing unit, a current power consumption of the processing unit;
receiving, by the PMIC, a current temperature of the processing unit;
comparing, by one of the processing unit or the PMIC, the measured current power consumption to an expected power consumption range for the processing unit;
comparing, by one of the processing unit or the PMIC, the current temperature of the processing unit to an expected temperature range for the processing unit; and
generating, by the processing unit, an alert in response to the measured current power consumption being outside the expected power consumption range or the current temperature measurement being outside of the expected temperature range.

11. The method of claim 10, wherein the measuring is performed in response to one or more defined conditions associated with one or more of an operational mode of the processing unit or a mission profile of the processing unit.

12. The method of claim 10 or 11, wherein the measuring comprises initiating a built-in self-test (BIST) of the processing unit.

13. The method of any of claims 10 to 12, wherein receiving the current temperature of the processing unit comprises receiving information indicative of a first temperature from a first temperature sensor of the PMIC and receiving information indicative of a second temperature from a second temperature sensor of the processing unit.

14. The method of any of claims 10 to 13, further comprising determining at least one of the expected power consumption range or the expected temperature range based at least in part on one or more of a group that includes an operational mode of the processing unit, mission profile data associated with the processing unit, or historical data associated with the processing unit.

15. The method of claim 14, wherein determining at least one expected range of the expected power consumption range or the expected temperature range comprises determining the at least one expected range based at least in part on a predicted failure of the processing unit.

## Amended claims

### Amended claims in accordance with Rule 137(2) EPC.

1. A system (200, 300), comprising:
a processing unit (260, 360) comprising one or more processors (370) and at least one temperature sensor (264, 364); and
a power management integrated circuit, PMIC, (210, 310) coupled to the processing unit (260, 360), the PMIC (210, 310) configured to:
measure (226, 227) a current power consumption of the processing unit (260, 360); and
receive (266) a current temperature measurement from the at least one temperature sensor (264, 364) of the processing unit (260, 360);
wherein one of the processing unit (260, 360) or the PMIC (210, 310) is configured to:
perform a first comparison of the measured current power consumption to an expected power consumption range for the processing unit (260, 360); and
perform a second comparison of the current temperature measurement to an expected temperature range for the processing unit (260, 360); and
wherein the processing unit (260, 360) is configured to generate an alert (282) in response to:
a determination based on the first comparison that the measured current power consumption is outside of the expected power consumption range; or
a determination based on the second comparison that the current temperature measurement is outside of the expected temperature range for the processing unit (260, 360).

2. The system (200, 300) of claim 1, wherein at least one of the first comparison or the second comparison is performed as at least part of a diagnostic test initiated in response to one or more defined conditions associated with one or more of an operational mode of the processing unit (260, 360) or a mission profile of the processing unit (260, 360).

3. The system (200, 300) of claim 2, wherein the diagnostic test comprises a built-in self-test, BIST, of the processing unit (260, 360).

4. The system (200, 300) of any of claims 2 or 3, wherein the PMIC (210, 310) comprises an internal PMIC temperature sensor (218, 228), and wherein the diagnostic test is initiated by the PMIC (210, 310) based at least in part on data from the internal PMIC temperature sensor (218, 228).

5. The system (200, 300) of any preceding claim, wherein the processing unit (260, 360) is further configured to determine at least one of the expected power consumption range or the expected temperature range based at least in part on one or more of a group that includes an operational mode of the processing unit (260, 360), mission profile data associated with the processing unit (260, 360), or historical data associated with the processing unit (260, 360).

6. The system (200, 300) of any preceding claim, wherein at least one of the expected power consumption range or the expected temperature range is based at least in part on a predicted failure of the processing unit (260, 360).

7. The system (200, 300) of any preceding claim, wherein the processing unit (260, 360) is configured to store information indicative of the measured current power consumption and the current temperature measurement in a non-volatile memory (262, 270, 380) for future use as historical data associated with the processing unit (260, 360).

8. The system (200, 300) of any preceding claim, wherein to generate the alert (282) comprises alerting a user of the processing unit (260, 360) to schedule maintenance operations for a system incorporating the processing unit (260, 360).

9. The system (200, 300) of any preceding claim, wherein to generate the alert (282) comprises initiating a transmission of information indicative of the alert (282) to an entity associated with the processing unit (260, 360), the entity being located remotely from the processing unit (260, 360).

10. A method (405, 505) comprising:
measuring (415, 510), by a power management integrated circuit, PMIC, (210, 310) coupled to a processing unit (260, 360), a current power consumption of the processing unit (260, 360);
receiving (415, 510), by the PMIC (210, 310), a current temperature of the processing unit (260, 360);
comparing (420, 520), by one of the processing unit (260, 360) or the PMIC (210, 310), the measured current power consumption to an expected power consumption range for the processing unit (260, 360);
comparing (420, 520), by one of the processing unit (260, 360) or the PMIC (210, 310), the current temperature of the processing unit (260, 360) to an expected temperature range for the processing unit (260, 360); and
generating (430, 530), by the processing unit (260, 360), an alert (282) in response to the measured current power consumption being outside the expected power consumption range or the current temperature measurement being outside of the expected temperature range.

11. The method (405) of claim 10, wherein the measuring (415) is performed in response to one or more defined conditions associated with one or more of an operational mode of the processing unit (260, 360) or a mission profile of the processing unit (260, 360).

12. The method (505) of claim 10 or 11, wherein the measuring (520) comprises initiating a built-in self-test, BIST, (505) of the processing unit (260, 360).

13. The method (405, 505) of any of claims 10 to 12, wherein receiving (415, 510) the current temperature of the processing unit (260, 360) comprises receiving information indicative of a first temperature from a first temperature sensor (218) of the PMIC (210, 310) and receiving information indicative of a second temperature from a second temperature sensor (264, 364) of the processing unit (260, 360).

14. The method (405, 505) of any of claims 10 to 13, further comprising determining at least one of the expected power consumption range or the expected temperature range based at least in part on one or more of a group that includes an operational mode of the processing unit (260, 360), mission profile data associated with the processing unit (260, 360), or historical data associated with the processing unit (260, 360).

15. The method (405, 505) of claim 14, wherein determining at least one expected range of the expected power consumption range or the expected temperature range comprises determining the at least one expected range based at least in part on a predicted failure of the processing unit (260, 360).
